# FASCICULE DE BREVET EUROPEEN

(11) **EP 3 238 273 B1**
(45) Date de publication et mention de la délivrance du brevet: **25.11.2020**
(21) Numéro de dépôt: 15817254.4
(22) Date de dépôt: 18.12.2015
(51) Int. Cl.: H01L 31/048

(54) **MODULE PHOTOVOLTAÏQUE COMPORTANT UNE COUCHE POLYMÉRIQUE POURVUE D'ÉVIDEMENTS FORMANT DES JOINTS DE DILATATION**
FOTOVOLTAIKMODUL MIT EINER POLYMERSCHICHT MIT DEHNUNGSFUGENBILDENDEN AUSSPARUNGEN
PHOTOVOLTAIC MODULE COMPRISING A POLYMER LAYER PROVIDED WITH RECESSES FORMING EXPANSION JOINTS

(30) Priorité: 26.12.2014 FR 1463351
(43) Date de publication de la demande: 01.11.2017
(73) Titulaire: Commissariat à l'Énergie Atomique et aux Énergies Alternatives, 75015 Paris (FR); Arkema France, 92700 Colombes (FR)
(72) Inventeur: PILAT, Eric, 73100 Brison-Saint-Innocent (FR); HIDALGO, Manuel, 69530 Brignais (FR); THIL, Dominique, 38110 Cessieu (FR); VITE, Marion, 73000 Chambéry (FR)
(74) Mandataire: Brevalex
(86) Numéro de dépôt international: PCT/EP2015/080432
(87) Numéro de publication internationale: WO 2016/102348

(56) Documents cités:
- WO-A2-2009/109180
- WO-A2-2012/009681
- WO-A2-2013/160375
- JP-B2- 5 287 487
- US-B1- 6 262 358

## Description

### DOMAINE TECHNIQUE

La présente invention se rapporte au domaine des modules photovoltaïques, qui comportent un ensemble de cellules photovoltaïques reliées entre elles électriquement, et notamment des cellules photovoltaïques dites « cristallines », c'est-à-dire qui sont à base de cristaux de silicium ou de polycristaux de silicium.

L'invention peut être mise en œuvre pour de nombreuses applications, étant particulièrement concernée par les applications qui requièrent l'utilisation de modules photovoltaïques pourvus de faces avant et/ou arrière réalisées à partir de matériaux polymères à fort coefficient de dilatation et épais, en particulier d'épaisseur supérieure ou égale à 0,5 mm. Elle peut ainsi notamment être appliquée pour des bâtiments tels que des habitats ou locaux industriels, par exemple pour la réalisation de leurs toitures, pour la conception de mobilier urbain, par exemple pour de l'éclairage public, la signalisation routière ou encore la recharge de voitures électriques, ou également pour son intégration sur des zones circulables, pour des piétons et/ou des véhicules, telles que des chaussées ou routes, des pistes cyclables, des plateformes industrielles, des places, des trottoirs, voire également être utilisée pour des applications nomades, en particulier pour une intégration sur des voitures, bus ou bateaux, entre autres.

L'invention propose ainsi un module photovoltaïque comportant une couche polymérique pourvue d'évidements formant des joints de dilatation, ainsi qu'un procédé de réalisation d'un tel module photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, notamment de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 300 µm.

Les cellules photovoltaïques peuvent être reliées électriquement en série entre elles par des éléments de contact électrique avant et arrière, appelés conducteurs de liaison, et formés par exemple par des bandes de cuivre, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,3 mm et un module de Young typiquement compris entre 2 et 400 MPa à température ambiante.

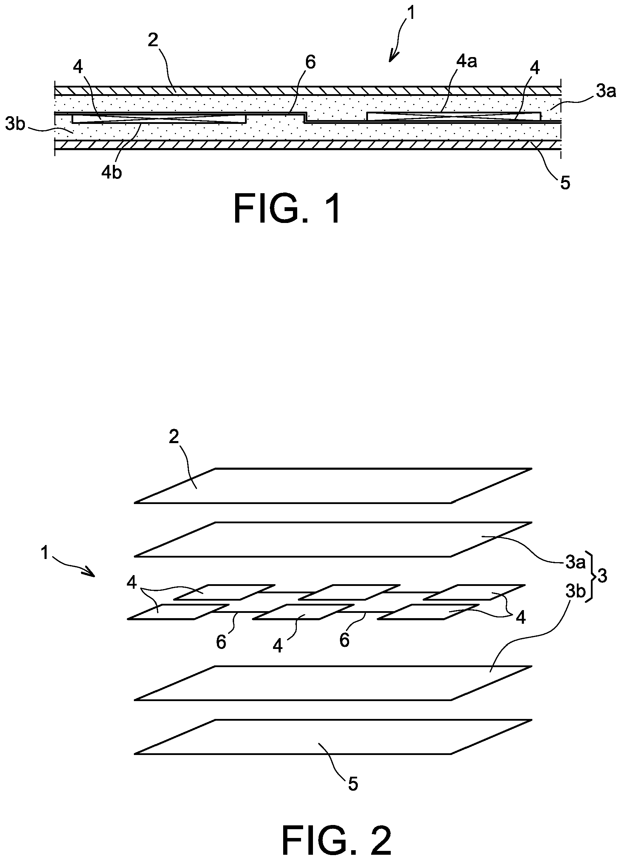

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur comprise entre 2 et 4 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement en série entre elles par des conducteurs de liaison 6 et immergées entre deux couches avant 3a et arrière 3b de matériau d'encapsulation formant toutes les deux un ensemble encapsulant 3.

De façon habituelle, le procédé de réalisation du module photovoltaïque 1 comporte une étape dite de lamination des différentes couches décrites précédemment, à une température supérieure ou égale à 100°C, voire 140°C, voire encore 150°C, et inférieure ou égale à 170°C, typiquement comprise entre 145 et 160°C, et pendant une période d'au moins 8 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. De plus, l'étape de lamination est également une étape pendant laquelle certains encapsulants dits réticulables présentent une réaction dite de réticulation qui permet de figer leurs propriétés mécaniques dans la plage des températures extrêmes supérieures d'utilisation.

Pendant cette opération de laminage (encore désigné par le terme lamination dans la présente description), les deux couches de matériau d'encapsulation 3a et 3b sont fondues pour ne former alors, après l'opération de lamination, qu'une seule couche d'ensemble encapsulant 3 dans laquelle sont noyées les cellules photovoltaïques 4.

Par ailleurs, pendant l'étape de lamination, le laminat (structure devant former le module photovoltaïque tel que représenté sur les figures 1 et 2) est introduit dans un équipement chauffant comprenant deux chambres inférieure et supérieure. Il est d'abord placé dans la chambre inférieure, en contact avec un plateau chauffant, et reste séparé de la chambre supérieure par une membrane flexible de manière à ce que l'opération de laminage comprenne au moins deux stades successifs : le premier pendant lequel un vide est réalisé dans les deux chambres afin de dégazer et d'équilibrer thermiquement le laminat; le deuxième pendant lequel on retourne à une pression proche de la pression atmosphérique dans la chambre supérieure de sorte à ce que le laminat soit compressé à chaud par la différence de pression entre les deux chambres.

Néanmoins, une telle étape de lamination pour réaliser le module photovoltaïque présente plusieurs inconvénients, en particulier lorsque la face avant et/ou la face arrière du module photovoltaïque sont réalisées en matériau polymère, ce qui peut être le cas pour des raisons de recherche de légèreté ou de flexibilité par rapport au verre.

En effet, la lamination présente les inconvénients majeurs de solliciter thermiquement la structure devant former le module photovoltaïque pendant la fabrication, et d'entraîner des réponses différentes en termes de contraintes de dilatation des différentes couches, notamment entre la face avant et/ou arrière en polymère et les autres couches.

De plus, ces inconvénients persistent à chaque fois que le module photovoltaïque est soumis à des sauts importants de température autres que ceux de l'étape de lamination, donc même après la fabrication du module photovoltaïque, notamment lors de la réalisation de tests normés dans des conditions durcies, sensées garantir une bonne tenue du module photovoltaïque lors de sa vie utile. On peut par exemple citer le test de cyclage thermique pendant lequel le module photovoltaïque peut être soumis à des cycles, au moins 200, relativement rapides, soit typiquement entre 4 et 6 par jour, de changement de température entre -40°C et 85°C.

Par ailleurs, comme indiqué auparavant, ces inconvénients sont particulièrement accentués lorsque la face avant et/ou la face arrière du module photovoltaïque, habituellement réalisées en verre épais, donc très raide, sont remplacées par un matériau du type polymère, plus léger, moins cassant que le verre, permettant de réaliser des faces avant ou arrière nettement moins épaisses, mais en conséquence nettement moins raide, comme par exemple le polycarbonate (PC) ou le polyméthacrylate de méthyle (PMMA). En effet, dans ce cas, les contraintes induites par la dilatation différentielle des différentes couches du module photovoltaïque peuvent être telles que des délaminations au sein des différentes interfaces du module, voire des cassures de cellules photovoltaïques, des mouvements des conducteurs de liaison, des cassures des faces avant et/ou arrière du module ou un gauchissement/fléchissement du module peuvent se produire.

Une première solution pour répondre à ces problématiques pourrait être alors de concevoir des structures pour module photovoltaïque parfaitement symétriques, obligeant à utiliser le même matériau pour la face avant et pour la face arrière du module, ce qui n'est pas toujours souhaitable ou réalisable. De plus, avoir des matériaux de même coefficient de dilatation sur les faces avant et arrière du module photovoltaïque ne constitue pas un remède lorsqu'un différentiel de température se crée dans des situations où les faces avant et arrière sont exposées à des températures différentes.

Une deuxième solution serait d'utiliser une épaisseur très importante d'ensemble encapsulant présentant alors un faible module de Young. De cette façon, ce serait l'ensemble encapsulant qui, en se déformant, éviterait de générer des contraintes trop importantes. Toutefois, cette solution n'est pas entièrement satisfaisante pour les raisons suivantes : en augmentant l'épaisseur de l'ensemble encapsulant, il devient plus lourd et moins flexible, et surtout présente un coût de fabrication trop élevé ; en outre, soumis à des cycles répétés, l'ensemble encapsulant fatigue relativement vite et il existe un risque fort de fluage ; enfin, une couche trop épaisse d'encapsulant diminuera aussi le flux de photons capturables par les cellules photovoltaïques.

Par ailleurs, des solutions ont également été proposées dans la littérature brevet quant à la problématique de dilatation thermique dans des modules photovoltaïques.

Ainsi, par exemple, la demande internationale WO 2013/160375 A2 décrit une adaptation des caractéristiques des matériaux constitutifs d'un module photovoltaïque pour atténuer les pertes optiques et les contraintes mécaniques. En particulier, elle divulgue l'utilisation d'un encapsulant à faible module de Young capable d'encaisser par déformation les dilatations différentielles.

En outre, les demandes internationales WO 2009/109180 A2 et WO 2012/009681 A2 enseignent l'ajout, dans le matériau de la face avant, de la face arrière ou de l'encapsulant du module photovoltaïque, d'additifs à faible coefficient de dilatation thermique (ou encore CTE pour « Coefficient of Thermal Expansion » en anglais) de sorte à faire baisser le coefficient de dilatation thermique global du matériau, et également pour améliorer la conductivité thermique du matériau.

Par ailleurs, le brevet JP 5 287487 B2 divulgue un module photovoltaïque pour un véhicule motorisé comprenant une face avant pourvue de canaux formant des éléments de dilatation.

Ces solutions de l'art antérieur paraissent néanmoins insuffisantes, le module de Young des encapsulants utilisés actuellement étant déjà bien bas, voire également coûteuses ou trop complexes à mettre en œuvre (additivation).

### EXPOSÉ DE L'INVENTION

Il existe un besoin pour concevoir une solution alternative de module photovoltaïque prévu pour permettre de réduire les inconvénients liés au phénomène de dilatation thermique de ses éléments constitutifs lorsqu'ils sont soumis à des variations de température, et notamment lorsque ces éléments constitutifs, réalisés dans des matériaux de nature et de propriétés thermomécaniques très différentes, présentent un coefficient de dilatation thermique élevé.

L'invention a pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque comportant au moins :
- une première couche transparente formant la face avant du module photovoltaïque destinée à recevoir un flux lumineux,
- une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et la pluralité de cellules photovoltaïques étant situés entre les première et deuxième couches,
au moins l'une des première et deuxième couches étant constituée d'au moins un matériau polymère, dans lequel sont formés des évidements constituant des joints de dilatation, ladite au moins l'une des première et deuxième couches pourvue des évidements étant d'un seul tenant, les évidements étant au moins partiellement occupés par un matériau de jointage dit « mou » présentant un module de Young à température ambiante inférieur au module de Young à température ambiante du matériau polymère de ladite au moins l'une des première et deuxième couches et une épaisseur inférieure ou égale à l'épaisseur du matériau polymère de ladite au moins l'une des première et deuxième couches et les évidements étant au moins en partie traversants.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau d'encapsulation, réunies entre elles après laminage pour former l'ensemble encapsulant.

En effet, initialement, c'est-à-dire avant toute opération de laminage, l'ensemble encapsulant est constitué par au moins deux couches de matériau d'encapsulation, dites couches de cœur, entre lesquelles la pluralité de cellules photovoltaïques est encapsulée. Toutefois, pendant l'opération de laminage des couches, les couches de matériau d'encapsulation fondent pour ne former, après l'opération de laminage, qu'une seule couche (ou ensemble) solidifiée dans laquelle sont noyées les cellules photovoltaïques.

Comme indiqué précédemment, l'ensemble encapsulant peut être formé à partir d'au moins deux couches de matériau d'encapsulation, ayant des épaisseurs identiques ou différentes, comportant un polymère du type élastomère (ou caoutchouc). Chaque couche de cœur peut par exemple consister en une couche (ou film) de poly(éthylène-acétate de vinyle) (EVA). Chaque couche de cœur peut présenter une épaisseur d'au moins 0,3 mm et un module de Young typiquement compris entre 2 et 400 MPa à température ambiante.

Par ailleurs, par l'expression « température ambiante », on entend une température comprise entre environ 15 et 30°C.

Grâce à l'invention, il peut ainsi être possible de réduire les contraintes liées à la dilatation thermique des couches constitutives d'un module photovoltaïque lorsque celui-ci est soumis à d'importantes variations de température. En particulier, la présence d'évidements formant des joints de dilatation dans la face avant et/ou dans la face arrière du module photovoltaïque, autrement dit dans une face « externe » du module, peut permettre de répondre aux problèmes énoncés précédemment. En effet, la présence d'un matériau mou dans les évidements d'une telle face externe permet de créer des zones de rupture dans le matériau polymère de la face externe qui atténuent les inconvénients liés à la dilatation thermique.

Le module photovoltaïque selon l'invention peut en outre comporter l'une ou plusieurs des caractéristiques suivantes prises isolément ou suivant toutes combinaisons techniques possibles.

La mesure du module de Young est avantageusement réalisée par la méthode de mesure selon la norme ISO 527-1:1993, datée du 15 juin 1993, annulée et remplacée en 2012 par la norme ISO 527-1:2012.

De préférence, ladite au moins l'une des première et deuxième couches correspond à la première couche du module photovoltaïque, c'est-à-dire à sa face avant. En variante, il peut également s'agir de la deuxième couche du module photovoltaïque, c'est-à-dire sa face arrière.

Le matériau de jointage peut présenter un module de Young à température ambiante inférieur à 20 fois, voire 100 fois, voire 500 fois, voire encore 1000 fois, le module de Young à température ambiante du matériau polymère de ladite au moins l'une des première et deuxième couches.

En particulier, le matériau de jointage peut présenter un module de Young à température ambiante inférieur ou égal à 50 MPa, voire 30 MPa, voire encore 10 MPa. De plus, le matériau polymère de ladite au moins l'une des première et deuxième couches peut présenter un module de Young à température ambiante compris entre 400 MPa et 10 GPa.

Par ailleurs, l'épaisseur du matériau polymère de ladite au moins l'une des première et deuxième couches peut être comprise entre 0,5 et 10 mm.

De plus, le coefficient de dilatation thermique (CTE) du matériau polymère de ladite au moins l'une des première et deuxième couches peut être compris entre 30 et 200 ppm/°C à des températures proches de la température ambiante. De même, le coefficient de dilatation thermique (CTE) du matériau de jointage occupant les évidements peut être compris entre 30 et 500 ppm/°C à des températures proches de la température ambiante.

Ledit au moins un matériau polymère de ladite au moins l'une des première et deuxième couches peut être choisi parmi du polyméthacrylate de méthyle (PMMA), notamment du PMMA monophasé (non choc) ou du PMMA multi-phasé (choc), notamment du PMMA choc nanostructuré, ou du polycarbonate (PC).

Par ailleurs, le matériau de jointage occupant les évidements peut être choisi parmi un matériau polymère, notamment identique au matériau polymère constituant l'ensemble encapsulant ou un gaz, pouvant être l'air ambiant.

De façon avantageuse, le matériau de jointage présente une bonne reprise élastique, de la souplesse et de la légèreté en comparaison avec le matériau polymère de ladite au moins l'une des première et deuxième couches, de sorte à pouvoir assurer son rôle de joint de dilatation en cas de contraintes thermiques élevées.

Selon un mode de réalisation de l'invention, le matériau de jointage correspond effectivement à un matériau, notamment sous forme solide ou gazeuse, occupant au moins partiellement l'évidement.

Toutefois, il est important de noter que, selon un autre mode de réalisation de l'invention, le matériau de jointage correspond simplement à de l'air ambiant. Autrement dit, chaque évidement peut n'être occupé que par de l'air. Aussi, l'expression « matériau de jointage » dans l'invention correspond à la présence effective d'un matériau, notamment sous forme solide ou gazeuse, ou à la présence d'air ambiant.

En outre, chacune des première et deuxième couches peut être constituée d'au moins un matériau polymère dans lequel sont formés des évidements constituant des joints de dilatation, chacune des première et deuxième couches pourvue des évidements étant d'un seul tenant, et les évidements étant au moins partiellement occupés par un matériau de jointage dit « mou » présentant un module de Young (E) à température ambiante inférieur au module de Young (E) de chacune des première et deuxième couches et une épaisseur inférieure ou égale à l'épaisseur de chacune des première et deuxième couches.

De plus, les évidements sont préférentiellement longiformes, se présentant notamment sous une forme oblongue, rectiligne et/ou en arc de cercle.

Les évidements comportent avantageusement, d'une part, un ensemble de premiers évidements dits « parallèles », c'est-à-dire des premiers évidements s'étendant selon leur plus grande dimension selon des premières directions (ou orientations) sensiblement parallèles ou confondues les unes par rapport aux autres, et d'autre part, un ensemble de deuxièmes évidements dits « perpendiculaires », c'est-à-dire des deuxièmes évidements s'étendant selon leur plus grande dimension selon des deuxièmes directions (ou orientations) sensiblement perpendiculaires aux premières directions (ou orientations) selon lesquelles les premiers évidements s'étendent selon leur plus grande dimension.

Les premiers évidements parallèles peuvent notamment correspondre à des évidements s'étendant selon leur plus grande dimension selon des directions rectilignes, toutes parallèles entre elles ou confondues. Les premiers évidements parallèles peuvent encore correspondre à des évidements s'étendant selon leur plus grande dimension selon des directions courbes, toutes parallèles entre elles ou confondues. Par « deux directions courbes parallèles entre elles », on entend qu'elles sont les lieux des extrémités d'un segment de longueur constante se déplaçant orthogonalement à sa direction. De plus, pour deux directions courbes parallèles entre elles, toute normale à l'une est une normale à l'autre.

De plus, la distance entre deux premiers évidements parallèles dits « adjacents », c'est-à-dire deux premiers évidements parallèles s'étendant selon leur plus grande dimension selon des premières directions sensiblement confondues et n'étant espacés l'un de l'autre par aucun autre premier évidement, ou deux premiers évidements parallèles s'étendant selon leur plus grande dimension selon des premières directions sensiblement parallèles et n'étant espacées l'une de l'autre par aucune autre première direction d'étendue d'un premier évidement parallèle, est avantageusement inférieure ou égale à 200 mm.

En effet, au-dessus d'une valeur de 200 mm de la distance entre deux premiers évidements adjacents, les effets contraignants de la dilatation différentielle peuvent se révéler trop importants.

En outre, la distance entre deux premiers évidements parallèles dits « adjacents », c'est-à-dire deux premiers évidements parallèles s'étendant selon leur plus grande dimension selon des premières directions sensiblement confondues et n'étant espacés l'un de l'autre par aucun autre premier évidement, ou deux premiers évidements parallèles s'étendant selon leur plus grande dimension selon des premières directions sensiblement parallèles et n'étant espacées l'une de l'autre par aucune autre première direction d'étendue d'un premier évidement parallèle, est avantageusement supérieure ou égale à 40 mm.

En effet, en dessous d'une valeur de 40 mm de la distance entre deux premiers évidements adjacents, les fonctions de protection aux chocs et de barrière à l'humidité de ladite au moins l'une des première et deuxième couches peuvent ne plus être assurées. De plus, la qualité optique de ladite au moins l'une des première et deuxième couches peut être dégradée.

Par ailleurs, la section de matière résiduelle entre un premier évidement parallèle et un deuxième évidement perpendiculaire peut être supérieure ou égale à 2 mm².

En effet, en dessous d'une valeur de 2 mm² pour la section de matière résiduelle entre un premier évidement parallèle et un deuxième évidement perpendiculaire, ladite au moins l'une des première et deuxième couche peut ne pas présenter une résistance suffisante pour être manipulée simplement.

De plus, les évidements peuvent présenter une largeur supérieure ou égale à 2 mm.

En effet, en dessous d'une valeur de 2 mm de la largeur des évidements, la réalisation des évidements, par exemple par la réalisation d'un moule de coulage ou par usinage, peut devenir trop complexe.

Les évidements peuvent également présenter une largeur inférieure ou égale à 3 mm.

En effet, au-dessus d'une valeur de 3 mm de la largeur des évidements, les fonctions de protection aux chocs, de barrière à l'humidité et la qualité optique de ladite au moins l'une des première et deuxième couches pourraient être dégradées.

Par ailleurs, les évidements peuvent être, au moins en partie, non débouchants.

Par « évidement non débouchant », on entend qu'il subsiste une épaisseur résiduelle de matière de ladite au moins l'une des première et deuxième couches en dessous ou au-dessous de l'évidement. Autrement dit encore, la partie du contour d'un évidement non débouchant selon sa plus grande dimension est délimitée, au moins d'un côté, par une épaisseur résiduelle de matière de ladite au moins l'une des première et deuxième couches. On peut encore parler d'évidement borgne.

Les évidements peuvent être non débouchants sur la surface externe du module photovoltaïque. Les évidements peuvent encore être non débouchants sur l'intérieur du module photovoltaïque, notamment sur l'ensemble encapsulant.

L'épaisseur résiduelle de matière de ladite au moins l'une des première et deuxième couches au niveau des évidements non débouchants peut être inférieure ou égale à 20 % de l'épaisseur du matériau polymère de ladite au moins l'une des première et deuxième couches, notamment inférieure ou égale à 0,1 mm.

En effet, au-dessus d'une telle valeur pour l'épaisseur résiduelle de matière de ladite au moins l'une des première et deuxième couches au niveau d'évidements non débouchants, l'efficacité des joints de dilatation que forment les évidements est significativement dégradée.

En outre, les évidements sont, au moins en partie, notamment en totalité, traversants.

Par « évidement traversant », on entend qu'il ne subsiste aucune épaisseur de matière de ladite au moins l'une des première et deuxième couches au niveau de l'évidement. Autrement dit, l'évidement traversant correspond à une ouverture totale de ladite au moins l'une des première et deuxième couches à l'endroit où il est formé.

Par ailleurs, un matériau de pénétration peut occuper au moins partiellement, notamment totalement, les évidements traversants et/ou les évidements non débouchants sur la surface externe du module photovoltaïque, le matériau de pénétration étant notamment constitué par le matériau de l'ensemble encapsulant.

Les évidements peuvent être disposés en configuration matricielle, c'est-à-dire de sorte que les évidements s'étendent sensiblement selon des lignes et des colonnes. Les évidements peuvent encore être disposés en configuration concentrique, c'est-à-dire de sorte qu'au moins une partie des évidements définissent sensiblement, seuls ou entre eux, des formes de cercles ou d'arcs de cercle.

Le module photovoltaïque selon l'invention peut aussi comporter une couche barrière aux gaz recouvrant ladite au moins l'une des première et deuxième couches, notamment constituée par un film de protection, dit film barrière aux gaz.

Par ailleurs, la première couche formant la face avant, et/ou la deuxième couche formant la face arrière, du module photovoltaïque peut être monocouche ou multicouche. En particulier, la première couche formant la face avant, et/ou la deuxième couche formant la face arrière, peut comporter un ensemble de couches transparentes ou non superposées entre elles.

Quand bien même la première couche formant la face avant du module photovoltaïque est transparente, la deuxième couche formant la face arrière du module photovoltaïque peut être ou non transparente, étant notamment opaque.

L'espacement entre deux cellules photovoltaïques voisines, ou encore consécutives ou adjacentes, peut être supérieur ou égal à 1 mm, notamment compris entre 1 et 30 mm, et de préférence supérieur ou égal à 3 mm, notamment compris entre 10 et 20 mm.

Par ailleurs, l'invention a encore pour objet, selon un autre de ses aspects, un procédé de réalisation d'un module photovoltaïque tel que défini précédemment, caractérisé en ce qu'il comporte les étapes successives suivantes :
a) réalisation des évidements dans le matériau polymère de ladite au moins l'une des première et deuxième couches du module photovoltaïque,
b) lamination de l'ensemble des couches constitutives du module photovoltaïque.

L'étape a) de réalisation des évidements peut être mise en œuvre par l'intermédiaire d'un moule de coulage ou d'un usinage.

Selon une première variante, l'étape a) de réalisation des évidements peut comporter la réalisation d'au moins une pluralité d'évidements traversants et éventuellement d'évidements non débouchants, sur la surface externe du module photovoltaïque, et le procédé selon l'invention peut comporter l'étape intermédiaire a'), après l'étape a) de réalisation des évidements et avant l'étape b) de lamination, consistant à placer ladite au moins l'une des première et deuxième couches pourvue des évidements directement au contact de l'ensemble encapsulant de sorte que, pendant l'étape b) de lamination, le matériau de l'ensemble encapsulant fonde et pénètre au moins partiellement dans les évidements, le matériau de l'ensemble encapsulant constituant alors au moins en partie ledit matériau de jointage.

Selon une deuxième variante, l'étape a) de réalisation des évidements peut comporter la réalisation d'au moins une pluralité d'évidements traversants et éventuellement d'évidements non débouchants, sur la surface externe du module photovoltaïque, et le procédé selon l'invention peut comporter l'étape intermédiaire a"), après l'étape a) de réalisation des évidements et avant l'étape b) de lamination, consistant à placer au moins un matériau de pénétration entre l'ensemble encapsulant et ladite au moins l'une des première et deuxième couches pourvue des évidements de sorte que, pendant l'étape b) de lamination, le matériau de pénétration fonde et pénètre au moins partiellement dans les évidements, le matériau de pénétration constituant alors au moins en partie ledit matériau de jointage.

Selon une troisième variante, l'étape a) de réalisation des évidements peut comporter la réalisation d'au moins une pluralité d'évidements traversants et éventuellement d'évidements non débouchants, sur la surface externe du module photovoltaïque, et le procédé selon l'invention peut comporter l'étape intermédiaire a'"), après l'étape a) de réalisation des évidements et avant l'étape b) de lamination, consistant à placer au moins un matériau de pénétration à l'intérieur des évidements puis à placer ladite au moins l'une des première et deuxième couches pourvue des évidements comprenant ledit au moins un matériau de pénétration directement au contact de l'ensemble encapsulant de sorte que, pendant l'étape b) de lamination, le matériau de pénétration déjà en place à l'intérieur des évidements constitue alors au moins en partie ledit matériau de jointage.

Ce matériau de pénétration peut par exemple être placé à l'intérieur des évidements par surmoulage de celui-ci sur la couche comprenant les évidements, étant par exemple constitué par un matériau thermo-fixe, notamment caoutchoutique. Le caractère « thermo-fixe » du matériau de pénétration peut ainsi lui permettre de ne pas fondre et de ne pas bouger pendant l'étape b) de lamination.

Par ailleurs, le procédé selon l'invention peut comporter l'étape c), après l'étape b) de lamination, de positionnement d'une couche barrière aux gaz en recouvrement de ladite au moins l'une des première et deuxième couches, notamment constituée par un film de protection, dit film barrière aux gaz.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 2 représente, en vue éclatée, le module photovoltaïque de la figure 1,
- les figures 3, 4 et 5 représentent, respectivement en perspective, en vue de dessus et en coupe, un premier exemple de réalisation d'une face avant d'un module photovoltaïque non conforme à l'invention,
- les figures 6 et 7 représentent, respectivement en perspective et en perspective agrandie, un deuxième exemple de réalisation d'une face avant d'un module photovoltaïque conforme à l'invention,
- la figure 8 représente, en vue de dessus, un troisième exemple de réalisation d'une face avant d'un module photovoltaïque conforme à l'invention,
- la figure 9 représente, en vue de dessus, un quatrième exemple de réalisation d'une face avant d'un module photovoltaïque conforme à l'invention,
- la figure 10 représente, en coupe, un exemple de module photovoltaïque conforme à l'invention comportant une couche barrière aux gaz,
- la figure 11 représente, en coupe, un autre exemple de module photovoltaïque conforme à l'invention comportant des évidements traversants dans lesquels une partie du matériau de l'ensemble encapsulant a pénétré,
- la figure 12 représente, en coupe, encore un autre exemple de module photovoltaïque non conforme à l'invention comportant des évidements non débouchants sur la surface externe du module photovoltaïque dans lesquels une partie du matériau de l'ensemble encapsulant a pénétré, et
- la figure 13 représente, en coupe, encore un autre exemple de module photovoltaïque conforme à l'invention comportant des évidements traversants dans lesquels une partie d'un matériau de pénétration ajouté au préalable sur l'ensemble encapsulant a pénétré.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 et 2 ont déjà été décrites dans la partie relative à l'état de la technique antérieure.

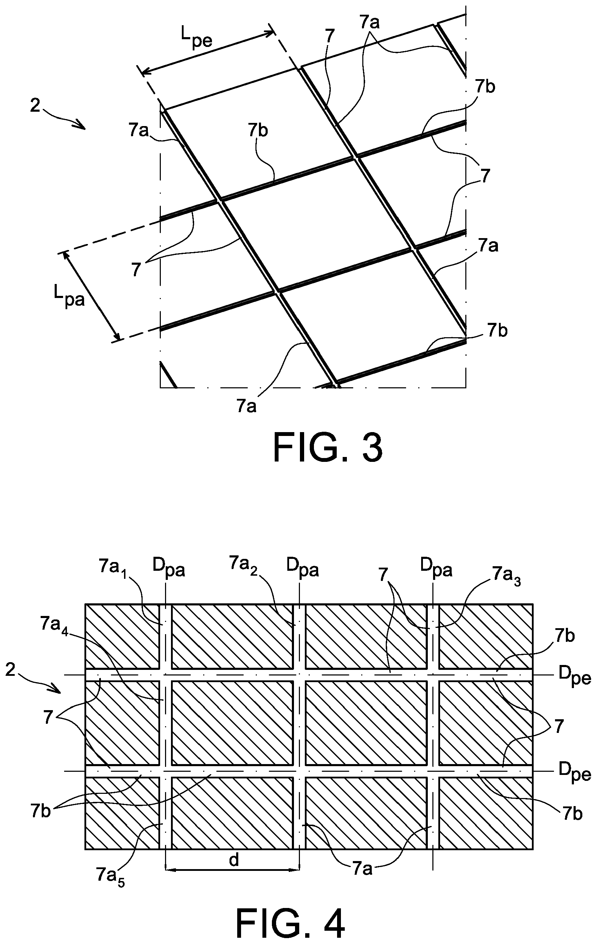

Dans tous les exemples décrits ci-après en référence aux figures 3 à 13, on considère que la face externe du module photovoltaïque 1, constituée d'un matériau polymère dans lequel sont formés des évidements 7 constituant des joints de dilatation, correspond à la première couche 2 du module photovoltaïque 1, autrement dit à la face avant 2 du module photovoltaïque 1.

Bien entendu, ce choix n'est nullement limitatif. Ainsi, en variante, la deuxième couche 5, soit la face arrière 5, du module photovoltaïque 1 pourrait correspondre à la face externe en matériau polymère pourvue d'évidements 7. En variante encore, chacune des première 2 et deuxième 5 couches, soit les faces avant 2 et arrière 5, du module photovoltaïque 1 pourrait être réalisée en matériau polymère et munie d'évidements 7 formant des joints de dilatation.

En outre, sur les figures 3 à 9, seule la face avant 2 du module photovoltaïque 1 est représentée. Ainsi, pour les autres éléments constitutifs du module photovoltaïque 1, il convient de se référer aux figures 1 et 2 décrites précédemment.

De plus, les faces avant 2 et arrière 5 du module photovoltaïque 1 sont préférentiellement réalisées en un matériau polymère choisi parmi du polyméthacrylate de méthyle (PMMA) ou du polycarbonate (PC). S'agissant du PMMA, on entend par cela un matériau polymère constitué de chaînes polymères à base de méthyl méthacrylate comme monomère majoritaire lors de la polymérisation. Ce matériau peut être mono ou multi-phasé, en référence au nombre des phases polymériques le constituant. Cette définition comprend ainsi, de manière non exclusive, le PMMA monophasé ou PMMA classique, dit aussi verre acrylique non modifié choc, comme celui commercialisé par la société Altuglas® sous différentes formes, couleurs, textures, et jeu de propriétés optiques et physico-chimiques (incluant les propriétés thermo-mécaniques). La définition comprend également le PMMA multi-phasé (au moins deux phases polymère distinctes) ou PMMA choc, comme le PMMA choc classique et le PMMA choc nanostructuré, tel que celui commercialisé par la société Altuglas® sous la marque Altuglas® Shield-Up®.

On se réfère tout d'abord aux figures 3 à 5 qui représentent, respectivement en perspective, en vue de dessus et en coupe, un premier exemple de réalisation d'un module photovoltaïque 1 non conforme à l'invention mais utile à la compréhension de l'invention.

La face avant 2 du module photovoltaïque 1, d'un seul tenant, est constituée d'un matériau polymère dans lequel sont formés des évidements 7 constituant des joints de dilatation.

Bien que non représenté sur les figures 3 à 5, chaque évidement 7 est au moins partiellement occupé par un matériau de jointage dit « mou » présentant un module de Young E à température ambiante inférieur au module de Young E à température ambiante du matériau polymère de la face avant 2, et notamment un module de Young E à température ambiante inférieur ou égal à 50 MPA, voire 30 MPa, voire encore 10 MPa, alors que le matériau polymère de la face avant 2 présente un module de Young E à température ambiante compris entre 400 MPa et 10 GPa.

La présence d'un tel matériau mou permet à la face avant 2 du module 1 de pouvoir compenser les inconvénients liés à la dilatation thermique.

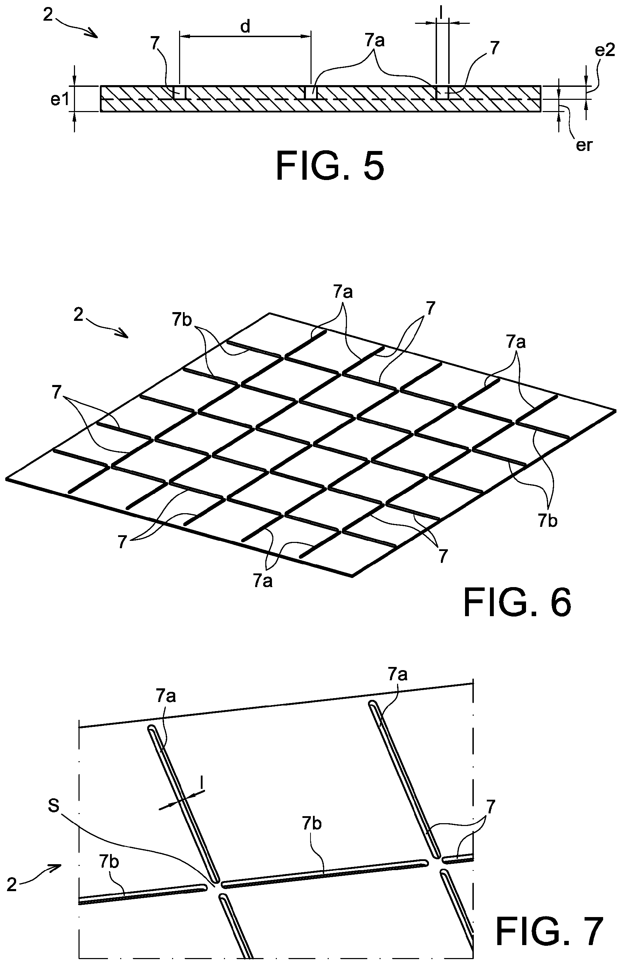

De plus, comme on peut le voir sur la figure 5, l'épaisseur e2 des évidements 7 est inférieure ou égale à l'épaisseur e1 du matériau polymère de la face avant 2, par exemple comprise entre 0,5 et 10 mm.

Le coefficient de dilatation thermique (CTE) du matériau polymère de la face avant 2 est quant à lui compris entre 30 et 200 ppm/°C à une température proche de la température ambiante, soit un fort coefficient de dilatation thermique, et le coefficient de dilatation thermique (CTE) du matériau de jointage occupant les évidements 7 est compris entre 30 et 500 ppm/°C à une température proche de la température ambiante.

De façon avantageuse, le matériau de jointage qui occupe les évidements 7 peut être choisi parmi un matériau polymère, notamment identique au matériau polymère constituant l'ensemble encapsulant 3 ou bien alors un matériau de pénétration 8 comme il sera expliqué par la suite, voire un gaz, notamment de l'air. Il est important de noter en effet que les évidements 7 peuvent n'être occupés que par de l'air ambiant selon un des modes de réalisation de l'invention. Aussi, au sens de l'invention, l'expression « matériau de jointage » ou « matériau mou » couvre également l'air ambiant.

De façon avantageuse, le matériau de jointage présente une bonne reprise élastique, de la souplesse et de la légèreté en comparaison avec le matériau polymère de la face avant 2, de sorte à pouvoir assurer son rôle de joint de dilatation en cas de contraintes thermiques élevées.

Par ailleurs, dans cet exemple de réalisation des figures 3 à 5, les évidements 7 sont longiformes et se présentent sous une forme rectiligne. Ils sont disposés en configuration matricielle, c'est-à-dire selon un assemblage de lignes et de colonnes continues, comme on peut le voir sur les figures 3 et 4.

De plus, les évidements 7 de l'exemple de réalisation des figures 3 à 5 sont non débouchants, et notamment non débouchants sur l'ensemble encapsulant 3 mais débouchent toutefois sur la surface externe du module photovoltaïque 1. Autrement dit, le contour des évidements 7 selon leur longueur est délimité en dessous par l'ensemble encapsulant 3.

De ce fait, il existe une épaisseur résiduelle eᵣ de matière de la face avant 2 au niveau des évidements 7 non débouchants, qui est inférieure ou égale à 20 % de l'épaisseur e1 du matériau polymère de la face avant 2, et notamment inférieure ou égale à 0,1 mm.

Par ailleurs, les évidements 7 comportent, d'une part, un ensemble de premiers évidements dits « parallèles » 7a, c'est-à-dire des premiers évidements 7a s'étendant selon leur plus grande dimension Lpa selon des premières directions Dpa sensiblement parallèles ou confondues les unes par rapport aux autres, et d'autre part, un ensemble de deuxièmes évidements dits « perpendiculaires » 7b, c'est-à-dire des deuxièmes évidements 7b s'étendant selon leur plus grande dimension Lpe selon des deuxièmes directions Dpe sensiblement perpendiculaires aux premières directions Dpa selon lesquelles les premiers évidements 7a s'étendent selon leur plus grande dimension Lpa.

En particulier, comme on peut le voir sur les figures 3 et 4, les premiers évidements parallèles 7a sont ici disposés de sorte à former les colonnes parallèles de direction Dpa, et les deuxièmes évidements perpendiculaires 7b sont ici disposés de sorte à former les lignes parallèles de direction Dpe. Les directions Dpe sont toutes perpendiculaires aux directions Dpa.

En outre, comme on peut le voir sur les figures 4 et 5, la distance d entre deux premiers évidements parallèles 7a dits « adjacents », c'est-à-dire deux premiers évidements parallèles 7a s'étendant selon leur plus grande dimension Lpa selon des premières directions Dpa sensiblement confondues et n'étant espacés l'un de l'autre par aucun autre premier évidement 7a, ou deux premiers évidements parallèles 7a s'étendant selon leur plus grande dimension Lpa selon des premières directions Dpa sensiblement parallèles et n'étant espacées l'une de l'autre par aucune autre première direction Dpa d'étendue d'un premier évidement parallèle 7a, est inférieure ou égale à 200 mm et supérieure ou égale à 40 mm.

A titre de remarque, sur la figure 4, les premiers évidements parallèles 7a₁ et 7a₂ d'une part, et les premiers évidements parallèles 7a₂ et 7a₃ d'autre part, constituent des premiers évidements parallèles adjacents. En effet, les premiers évidements parallèles 7a₁ et 7a₂ d'une part, et les premiers évidements parallèles 7a₂ et 7a₃ d'autre part, constituent deux premiers évidements parallèles s'étendant selon leur plus grande dimension Lpa selon des premières directions Dpa sensiblement parallèles et n'étant espacées l'une de l'autre par aucune autre première direction Dpa.

En revanche, les premiers évidements parallèles 7a₁ et 7a₃ ne sont pas adjacents puisque le premier évidement parallèle 7a₂ se situe entre eux.

De plus, les premiers évidements parallèles 7a₁ et 7a₄ sont des évidements adjacents, car ils constituent deux premiers évidements parallèles s'étendant selon leur plus grande dimension Lpa selon des premières directions Dpa sensiblement confondues et n'étant espacés l'un de l'autre par aucun autre premier évidement.

Toutefois, les premiers évidements parallèles 7a₁ et 7a₅ ne sont pas adjacents puisque le premier évidement parallèle 7a₄ se situe entre eux.

En référence aux figures 6 et 7, on a représenté, respectivement en perspective et en perspective agrandie, un deuxième exemple de réalisation de la face avant 2 d'un module photovoltaïque 1 selon l'invention.

Seuls les éléments qui diffèrent du premier exemple de réalisation des figures 3 à 5 sont détaillés ci-après.

Ainsi, dans ce deuxième exemple, les évidements 7 sont longiformes et se présentent sous une forme oblongue. Ils sont traversants (ouverture totale) et disposés selon une configuration matricielle, à savoir sous la forme de lignes et de colonnes, comme selon le premier exemple des figures 3 à 5.

Les mêmes remarques que précédemment concernant le dimensionnement des évidements 7 sont applicables ici.

En outre, comme on peut le voir sur la figure 7, la section s de matière résiduelle entre un premier évidement parallèle 7a et un deuxième évidement perpendiculaire 7b est supérieure ou égale à 2 mm².

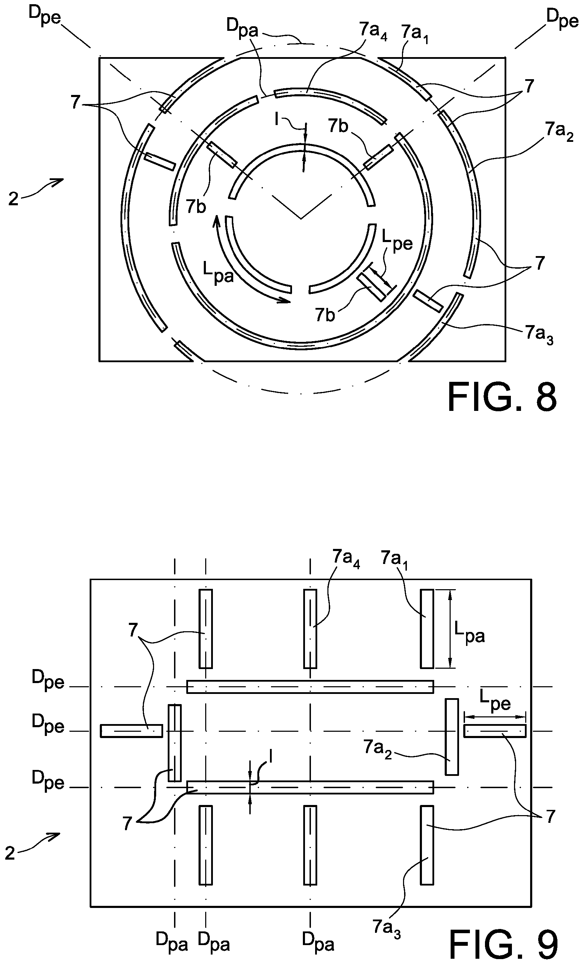

Par ailleurs, en référence à la figure 8, on a représenté en vue de dessus un troisième exemple de réalisation de la face avant 2 d'un module photovoltaïque 1 selon l'invention.

A la différence des premier et deuxième exemples de réalisation décrits auparavant, les évidements 7 sont, dans l'exemple de la figure 8, disposés selon une configuration concentrique, c'est-à-dire qu'ils sont sensiblement disposés selon des cercles ou portions de cercle.

Les évidements 7 sont longiformes mais se présentent ici sous une forme d'arc de cercle pour les premiers évidements parallèles 7a et sous une forme rectiligne pour les deuxièmes évidements perpendiculaires 7b.

A titre de remarque, dans ce troisième exemple de la figure 8, les premières directions Dpa correspondent à des courbes parallèles ou confondues entre elles. Les deuxièmes directions Dpe sont des droites perpendiculaires aux premières directions Dpa.

De plus, les plus grandes dimensions Lpa des premiers évidements parallèles 7a correspondent aux longueurs des arcs de cercle correspondants, tandis que les plus grandes dimensions Lpe des deuxièmes évidements perpendiculaires 7b correspondent aux longueurs des segments rectilignes correspondants.

Par ailleurs, à titres d'exemples, les premiers évidements parallèles 7a₁ et 7a₄ sont adjacents, de même que les premiers évidements 7a₁ et 7a₂. En revanche, les premiers évidements 7a₁ et 7a₃ ne sont pas adjacents.

Les mêmes remarques que précédemment concernant le dimensionnement des évidements 7 sont applicables ici.

En référence à la figure 9, on a représenté encore un quatrième exemple de réalisation de la face avant 2 d'un module photovoltaïque 1 conforme à l'invention.

Dans cet exemple, les évidements 7 sont disposés selon une configuration matricielle et concentrique. En effet, d'une part les premiers évidements parallèles 7a sont disposés selon des colonnes et les deuxièmes évidements perpendiculaires 7b sont disposés selon des lignes. D'autre part, la disposition des évidements 7 semble définir des cercles concentriques.

A titre de remarques, les premiers évidements parallèles 7a₁ et 7a₂ sont adjacents, de même que les premiers évidements parallèles 7a₁ et 7a₄. En revanche, les premiers évidements parallèles 7a₁ et 7a₃ ne sont pas adjacents.

Par ailleurs, dans tous les exemples décrits, la largeur I des évidements 7, par exemple représentée sur la figure 5 ou les figures 7 à 9, est supérieure ou égale à 2 mm, et inférieure ou égale à 3 mm.

De plus, dans les troisième et quatrième exemples respectivement des figures 8 et 9, les évidements peuvent être traversants ou encore non débouchants, soit sur la surface externe du module photovoltaïque 1, soit sur l'ensemble encapsulant 3.

En outre, lorsque les évidements 7 sont traversants ou non débouchants sur la surface externe du module photovoltaïque 1, ils peuvent être occupés au moins partiellement par un matériau de pénétration 8 ou par l'ensemble encapsulant 3, comme décrit par la suite, qui joue alors le rôle de matériau de jointage.

Il est de plus à noter que, dans les exemples décrits précédemment en référence aux figures 3 à 7 et 9, la distinction entre premiers évidements parallèles 7a et premiers évidements perpendiculaires 7b est arbitraire, compte-tenu des configurations de positionnement représentées. Autrement dit, il est possible d'inverser les éléments désignés sur ces figures comme étant les premiers évidements parallèles 7a et les éléments désignés sur ces figures comme étant les deuxièmes évidements perpendiculaires 7b, de sorte que les caractéristiques précédemment énoncées pour les premiers évidements parallèles 7a, notamment relatives à la distance d, valent pour les deuxièmes évidements perpendiculaires 7b, et inversement.

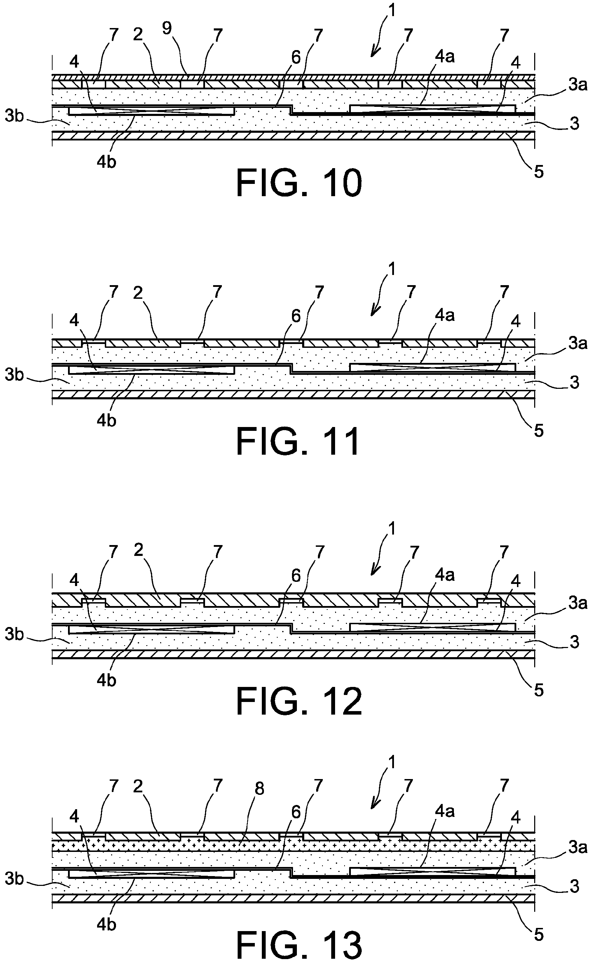

On va maintenant décrire en référence aux figures 10 à 13 différents exemples de modules photovoltaïques 1, obtenus selon diverses mises en œuvre du procédé de réalisation selon l'invention.

Tout d'abord, on a représenté sur la figure 10, en coupe, un exemple de module photovoltaïque 1 conforme à l'invention comportant une couche barrière aux gaz 9.

Dans cet exemple, le module photovoltaïque 1 comporte une face avant 2 pourvue d'évidements traversants 7, et la couche barrière aux gaz 9, constituée par exemple par un film de protection 9, dit film barrière aux gaz, recouvre la face avant 2 et les évidements traversants 7.

De cette façon, la couche barrière aux gaz 9 peut par exemple permettre de limiter la pénétration de vapeurs d'eau et/ou d'oxygène par les évidements traversants 7.

Par ailleurs, la figure 11 représente, en coupe, un autre exemple de module photovoltaïque 1 conforme à l'invention comportant des évidements traversants 7 dans lesquels une partie du matériau de l'ensemble encapsulant 3 a pénétré.

En effet, lors de l'étape de lamination de l'ensemble des couches constitutives du module photovoltaïque 1, le matériau de l'ensemble encapsulant 3 peut fondre et ainsi venir occuper au moins en partie les évidements traversants 7, constituant alors le matériau de jointage.

En outre, la figure 12 représente, en coupe, encore un autre exemple de module photovoltaïque 1 non conforme à l'invention, mais utile à la compréhension de l'invention, comportant des évidements non débouchants 7 sur la surface externe du module photovoltaïque 1 dans lesquels une partie du matériau de l'ensemble encapsulant 3 a pénétré.

Tout comme pour l'exemple précédent, l'élévation de température pendant l'étape de lamination provoque la pénétration du matériau de l'ensemble encapsulant 3 dans les évidements 7, qui constitue alors le matériau de jointage.

Enfin, la figure 13 représente, en coupe, un autre exemple de module photovoltaïque 1 conforme à l'invention comportant des évidements traversants 7 dans lesquels une partie d'un matériau de pénétration 8, ajouté au préalable sur l'ensemble encapsulant 3, a pénétré.

Autrement dit, une couche d'un matériau de pénétration 8 est ajoutée sur l'ensemble encapsulant 3 avant application de la face avant 2, puis l'étape de lamination permet le chauffage du matériau de pénétration 8 et son écoulement dans les évidements 7, le matériau de pénétration 8 constituant alors le matériau de jointage.

Dans tous les cas, la présence des évidements 7 sur la face avant 2 du module photovoltaïque 1 et la présence du matériau de jointage dans ces évidements 7 permettent de limiter les effets contraignants de la dilatation thermique décrits auparavant.

Bien entendu, l'invention n'est pas limitée aux exemples de réalisation qui viennent d'être décrits. Diverses modifications peuvent y être apportées par l'homme du métier.

L'expression « comportant un » doit être comprise comme étant synonyme de « comportant au moins un », sauf si le contraire est spécifié.

## Revendications

1. Module photovoltaïque (1) comportant au moins :
- une première couche (2) transparente formant la face avant du module photovoltaïque (1) destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches,
au moins l'une des première (2) et deuxième (5) couches étant constituée d'au moins un matériau polymère, dans lequel sont formés des évidements (7) constituant des joints de dilatation, ladite au moins l'une des première (2) et deuxième (5) couches pourvue des évidements (7) étant d'un seul tenant,
les évidements (7) étant au moins partiellement occupés par un matériau de jointage dit « mou » présentant un module de Young (E) à température ambiante inférieur au module de Young (E) à température ambiante du matériau polymère de ladite au moins l'une des première (2) et deuxième (5) couches et une épaisseur (e2) inférieure ou égale à l'épaisseur (e1) du matériau polymère de ladite au moins l'une des première (2) et deuxième (5) couches,
**caractérisé en ce que** les évidements (7) sont au moins en partie traversants.

2. Module selon la revendication 1, **caractérisé en ce que** le matériau de jointage présente un module de Young (E) à température ambiante inférieur à 20 fois, voire 100 fois, voire 500 fois, voire encore 1000 fois, le module de Young (E) à température ambiante du matériau polymère de ladite au moins l'une des première (2) et deuxième (5) couches, et notamment, **en ce que** le matériau de jointage présente un module de Young (E) à température ambiante inférieur ou égal à 50 MPa, notamment 30 MPa, voire 10 MPa, et **en ce que** le matériau polymère de ladite au moins l'une des première (2) et deuxième (5) couches présente un module de Young (E) à température ambiante compris entre 400 MPa et 10 GPa.

3. Module selon l'une des revendications précédentes, **caractérisé en ce que** :
- l'épaisseur (e1) du matériau polymère de ladite au moins l'une des première (2) et deuxième (5) couches est comprise entre 0,5 et 10 mm, et/ou,
- **en ce que** le coefficient de dilatation thermique (CTE) du matériau polymère de ladite au moins l'une des première (2) et deuxième (5) couches est compris entre 30 et 200 ppm/°C à des températures proches de la température ambiante, et **en ce que** le coefficient de dilatation thermique (CTE) du matériau de jointage occupant les évidements (7) est compris entre 30 et 500 ppm/°C à des températures proches de la température ambiante, et/ou,
- **en ce que** ledit au moins un matériau polymère de ladite au moins l'une des première (2) et deuxième (5) couches est choisi parmi du polyméthacrylate de méthyle (PMMA), notamment du PMMA monophasé ou du PMMA multi-phasé, notamment du PMMA choc nanostructuré, ou du polycarbonate (PC), et/ou,
- **en ce que** le matériau de jointage occupant les évidements (7) est choisi parmi un matériau polymère, notamment identique au matériau polymère constituant l'ensemble encapsulant (3), un gaz, notamment de l'air ambiant.

4. Module selon l'une quelconque des revendications précédentes, **caractérisé en ce que** chacune des première (2) et deuxième (5) couches est constituée d'au moins un matériau polymère dans lequel sont formés des évidements (7) constituant des joints de dilatation, chacune des première (2) et deuxième (5) couches pourvue des évidements (7) étant d'un seul tenant, et les évidements (7) étant au moins partiellement occupés par un matériau de jointage dit « mou » présentant un module de Young (E) à température ambiante inférieur au module de Young (E) de chacune des première (2) et deuxième (5) couches et une épaisseur (e2) inférieure ou égale à l'épaisseur (e1) de chacune des première (2) et deuxième (5) couches.

5. Module selon l'une quelconque des revendications précédentes, **caractérisé en ce que** les évidements (7) sont longiformes, se présentant notamment sous une forme oblongue, rectiligne et/ou en arc de cercle.

6. Module selon l'une quelconque des revendications précédentes, **caractérisé en ce que** les évidements (7) comportent, d'une part, un ensemble de premiers évidements dits « parallèles » (7a), c'est-à-dire des premiers évidements (7a) s'étendant selon leur plus grande dimension (Lpa) selon des premières directions (Dpa) sensiblement parallèles ou confondues les unes par rapport aux autres, et d'autre part, un ensemble de deuxièmes évidements dits « perpendiculaires » (7b), c'est-à-dire des deuxièmes évidements (7b) s'étendant selon leur plus grande dimension (Lpe) selon des deuxièmes directions (Dpe) sensiblement perpendiculaires aux premières directions (Dpa) selon lesquelles les premiers évidements (7a) s'étendent selon leur plus grande dimension (Lpa), et optionnellement, **en ce que** la distance (d) entre deux premiers évidements parallèles (7a) dits « adjacents », c'est-à-dire deux premiers évidements parallèles (7a) s'étendant selon leur plus grande dimension (Lpa) selon des premières directions (Dpa) sensiblement confondues et n'étant espacés l'un de l'autre par aucun autre premier évidement (7a), ou deux premiers évidements parallèles (7a) s'étendant selon leur plus grande dimension (Lpa) selon des premières directions (Dpa) sensiblement parallèles et n'étant espacées l'une de l'autre par aucune autre première direction (Dpa) d'étendue d'un premier évidement parallèle (7a), est inférieure ou égale à 200 mm, et/ou, **en ce que** la distance (d) entre deux premiers évidements parallèles (7a) dits « adjacents », c'est-à-dire deux premiers évidements parallèles (7a) s'étendant selon leur plus grande dimension (Lpa) selon des premières directions (Dpa) sensiblement confondues et n'étant espacés l'un de l'autre par aucun autre premier évidement (7a), ou deux premiers évidements parallèles (7a) s'étendant selon leur plus grande dimension (Lpa) selon des premières directions (Dpa) sensiblement parallèles et n'étant espacées l'une de l'autre par aucune autre première direction (Dpa) d'étendue d'un premier évidement parallèle (7a), est supérieure ou égale à 40 mm, et/ou, **en ce que** la section (s) de matière résiduelle entre un premier évidement parallèle (7a) et un deuxième évidement perpendiculaire (7b) est supérieure ou égale à 2 mm².

7. Module selon l'une quelconque des revendications précédentes, **caractérisé en ce que** :
- les évidements (7) présentent une largeur (I) supérieure ou égale à 2 mm, et/ou,
- **en ce que** les évidements (7) présentent une largeur (I) inférieure ou égale à 3 mm, et/ou,
- **en ce que** les évidements (7) sont en partie non débouchants et en partie traversants, et optionnellement, **en ce que** l'épaisseur résiduelle (eᵣ) de matière de ladite au moins l'une des première (2) et deuxième (5) couches au niveau des évidements (7) non débouchants est inférieure ou égale à 20 % de l'épaisseur (e1) du matériau polymère de ladite au moins l'une des première (2) et deuxième (5) couches, notamment inférieure ou égale à 0,1 mm.

8. Module selon l'une quelconque des revendications précédentes, **caractérisé en ce que** les évidements (7) sont en totalité traversants.

9. Module selon la revendication 7 ou 8, **caractérisé en ce qu'**un matériau de pénétration (8) occupe au moins partiellement, notamment totalement, les évidements traversants (7) et/ou les évidements non débouchants (7) sur la surface externe du module photovoltaïque (1), le matériau de pénétration (8) étant notamment constitué par le matériau de l'ensemble encapsulant (3).

10. Module selon l'une quelconque des revendications précédentes, **caractérisé en ce que** :
- les évidements (7) sont disposés en configuration matricielle, c'est-à-dire de sorte que les évidements (7) s'étendent sensiblement selon des lignes et des colonnes, et/ou,
- **en ce que** les évidements (7) sont disposés en configuration concentrique, c'est-à-dire de sorte qu'au moins une partie des évidements (7) définissent sensiblement, seuls ou entre eux, des formes de cercles ou d'arcs de cercle.

11. Module selon l'une quelconque des revendications précédentes, **caractérisé en ce qu'**il comporte en outre une couche barrière aux gaz (9) recouvrant ladite au moins l'une des première (2) et deuxième (5) couches, notamment constituée par un film de protection (9), dit film barrière aux gaz.

12. Procédé de réalisation d'un module photovoltaïque (1) selon l'une quelconque des revendications précédentes, **caractérisé en ce qu'**il comporte les étapes successives suivantes :
a) réalisation des évidements (7) dans le matériau polymère de ladite au moins l'une des première (2) et deuxième (5) couches du module photovoltaïque (1),
b) lamination de l'ensemble des couches constitutives (2, 3, 4, 5) du module photovoltaïque (1).

13. Procédé selon la revendication 12, **caractérisé en ce que** l'étape a) de réalisation des évidements (7) est mise en œuvre par l'intermédiaire d'un moule de coulage ou d'un usinage.

14. Procédé selon la revendication 12 ou 13, **caractérisé en ce que** :
- l'étape a) de réalisation des évidements (7) comporte la réalisation d'au moins une pluralité d'évidements (7) traversants, et éventuellement d'évidements (7) non débouchants, sur la surface externe du module photovoltaïque (1), et **en ce qu'**il comporte l'étape intermédiaire a'), après l'étape a) de réalisation des évidements (7) et avant l'étape b) de lamination, consistant à placer ladite au moins l'une des première (2) et deuxième (5) couches pourvue des évidements (7) directement au contact de l'ensemble encapsulant (3) de sorte que, pendant l'étape b) de lamination, le matériau de l'ensemble encapsulant (3) fonde et pénètre au moins partiellement dans les évidements (7), le matériau de l'ensemble encapsulant (3) constituant alors au moins en partie ledit matériau de jointage, ou,
- **en ce que** l'étape a) de réalisation des évidements (7) comporte la réalisation d'au moins une pluralité d'évidements (7) traversants, et éventuellement d'évidements (7) non débouchants, sur la surface externe du module photovoltaïque (1), et **en ce qu'**il comporte l'étape intermédiaire a"), après l'étape a) de réalisation des évidements (7) et avant l'étape b) de lamination, consistant à placer au moins un matériau de pénétration (8) entre l'ensemble encapsulant (3) et ladite au moins l'une des première (2) et deuxième (3) couches pourvue des évidements (7) de sorte que, pendant l'étape b) de lamination, le matériau de pénétration (8) fonde et pénètre au moins partiellement dans les évidements (7), le matériau de pénétration (8) constituant alors au moins en partie ledit matériau de jointage, ou,
- **en ce que** l'étape a) de réalisation des évidements (7) comporte la réalisation d'au moins une pluralité d'évidements (7) traversants, et éventuellement d'évidements (7) non débouchants, sur la surface externe du module photovoltaïque (1), et **en ce qu'**il comporte l'étape intermédiaire a'"), après l'étape a) de réalisation des évidements (7) et avant l'étape b) de lamination, consistant à placer au moins un matériau de pénétration (8) à l'intérieur des évidements (7) puis à placer ladite au moins l'une des première (2) et deuxième (3) couches pourvue des évidements (7) comprenant ledit au moins un matériau de pénétration (8) directement au contact de l'ensemble encapsulant (3) de sorte que, pendant l'étape b) de lamination, le matériau de pénétration (8) déjà en place à l'intérieur des évidements (7) constitue alors au moins en partie ledit matériau de jointage.

15. Procédé selon l'une quelconque des revendications 12 à 14, **caractérisé en ce qu'**il comporte l'étape c), après l'étape b) de lamination, de positionnement d'une couche barrière aux gaz (9) en recouvrement de ladite au moins l'une des première (2) et deuxième (5) couches, notamment constituée par un film de protection (9), dit film barrière aux gaz.

## Patentansprüche

1. Fotovoltaikmodul (1), zumindest enthaltend:
- eine erste transparente Schicht (2), die die Vorderseite des Fotovoltaikmoduls (1) bildet und dazu bestimmt ist, einen Lichtstrom zu empfangen,
- eine Vielzahl von fotovoltaischen Zellen (4), die nebeneinander angeordnet und elektrisch miteinander verbunden sind,
- eine Einkapselungsanordnung (3), die die Vielzahl der fotovoltaischen Zellen (4) einkapselt,
- eine zweite Schicht (5), die die Rückseite des Fotovoltaikmoduls (1) bildet, wobei die Einkapselungsanordnung (3) und die Vielzahl der fotovoltaischen Zellen (4) zwischen der ersten (2) und der zweiten (5) Schicht liegen,
wobei
zumindest eine aus erster (2) und zweiter Schicht (5) aus einem Polymermaterial besteht, in welchem Ausnehmungen (7) ausgebildet sind, die Dehnungsfugen bilden, wobei die zumindest eine aus erster (2) und zweiter Schicht (5), die mit den Ausnehmungen (7) versehen ist, einstückig ausgeführt ist,
wobei die Ausnehmungen (7) zumindest teilweise von einem sogenannten "weichen" Fugenmaterial eingenommen werden, das bei Raumtemperatur einen Elastizitätsmodul (E) hat, der niedriger ist als der Elastizitätsmodul (E) des Polymermaterials der zumindest einen aus erster (2) und zweiter (5) Schicht bei Raumtemperatur, und eine Dicke (e2) hat, die geringer oder gleich der Dicke (e1) des Polymermaterials der zumindest einen aus erster (2) und zweiter (5) Schicht ist,
**dadurch gekennzeichnet, dass**
die Ausnehmungen (7) zumindest teilweise durchgehend sind.

2. Modul nach Anspruch 1,
**dadurch gekennzeichnet, dass** das Fugenmaterial bei Raumtemperatur einen Elastizitätsmodul (E) von weniger als dem 20-fachen bzw. dem 100-fachen bzw. dem 500-fachen bzw. dem 1000-fachen des Elastizitätsmoduls (E) des Polymermaterials der zumindest einen aus erster (2) und zweiter (5) Schicht bei Raumtemperatur aufweist, und insbesondere
dass das Fugenmaterial bei Raumtemperatur einen Elastizitätsmodul (E) von weniger als oder gleich 50 MPa, insbesondere 30 MPa bzw. 10 MPa, aufweist und dass das Polymermaterial der zumindest einen aus erster (2) und zweiter (5) Schicht bei Raumtemperatur einen Elastizitätsmodul (E) zwischen 400 MPa und 10 GPa aufweist.

3. Modul nach einem der vorhergehenden Ansprüche,
**dadurch gekennzeichnet, dass**
- die Dicke (e1) des Polymermaterials der zumindest einen aus erster (2) und zweiter (5) Schicht zwischen 0,5 und 10 mm liegt, und/oder
- der Wärmeausdehnungskoeffizient (WAK) des Polymermaterials der zumindest einen aus erster (2) und zweiter (5) Schicht bei Temperaturen nahe der Raumtemperatur zwischen 30 und 200 ppm/°C liegt, und dass der Wärmeausdehnungskoeffizient (WAK) des Fugenmaterials, das die Ausnehmungen (7) einnimmt, bei Temperaturen nahe der Raumtemperatur zwischen 30 und 500 ppm/°C liegt, und/oder dass
- das zumindest eine Polymermaterial der zumindest einen aus erster (2) und zweiter (5) Schicht ausgewählt ist aus Polymethylmethacrylat (PMMA), insbesondere einphasigem PMMA oder mehrphasigem PMMA, insbesondere nanostrukturiertem, schlagzähem PMMA, oder Polycarbonat (PC), und/oder dass
- das Fugenmaterial, das die Ausnehmungen (7) einnimmt, ausgewählt ist aus einem Polymermaterial, das insbesondere mit dem die Einkapselungsanordnung (3) bildenden Polymermaterial identisch ist, einem Gas, insbesondere Umgebungsluft.

4. Modul nach einem der vorhergehenden Ansprüche,
**dadurch gekennzeichnet, dass** jede aus erster (2) und zweiter (5) Schicht aus zumindest einem Polymermaterial besteht, in dem Ausnehmungen (7) ausgebildet sind, die Dehnungsfugen bilden, wobei jede aus erster (2) und zweiter (5) Schicht, die mit den Ausnehmungen (7) versehen sind, einstückig ausgebildet sind, und wobei die Ausnehmungen (7) zumindest teilweise von einem sogenannten "weichen" Fugenmaterial eingenommen werden, das bei Raumtemperatur einen Elastizitätsmodul (E) hat, der niedriger ist als der Elastizitätsmodul (E) jeder aus erster (2) und zweiter (5) Schicht, und eine Dicke (e2) hat, die geringer oder gleich der Dicke (e1) jeder aus erster (2) und zweiter (5) Schicht ist.

5. Modul nach einem der vorhergehenden Ansprüche,
**dadurch gekennzeichnet, dass** die Ausnehmungen (7) länglich sind und insbesondere eine langgestreckte, geradlinige und/oder bogenförmige Form haben.

6. Modul nach einem der vorhergehenden Ansprüche,
**dadurch gekennzeichnet, dass** die Ausnehmungen (7) einerseits einen Satz erster, so genannter "paralleler" Ausnehmungen (7a), d.h. erster Ausnehmungen (7a), die entlang ihrer längsten Abmessung (Lpa) in ersten Richtungen (Dpa) im Wesentlichen parallel zueinander verlaufen oder zusammenfallen, aufweisen sowie andererseits einen Satz zweiter, so genannter "senkrechter" Ausnehmungen (7b), d.h. zweiter Ausnehmungen (7b), die entlang ihrer längsten Abmessung (Lpa) in zweiten Richtungen (Dpa) im Wesentlichen senkrecht zu den ersten Richtungen (Dpa) verlaufen, in denen die ersten Ausnehmungen (7a) entlang ihrer größten Abmessung (Lpa) verlaufen, und optional
dass der Abstand (d) zwischen zwei ersten parallelen Ausnehmungen (7a), die als "benachbart" bezeichnet werden, d.h. zwei ersten parallelen Ausnehmungen (7a), die sich entlang ihrer größten Abmessung (Lpa) in im Wesentlichen zusammenfallenden ersten Richtungen (Dpa) erstrecken und durch keine weitere erste Ausnehmung (7a) voneinander beabstandet sind, oder zwei ersten parallelen Ausnehmungen (7a), die sich entlang ihrer größten Abmessung (Lpa) in im Wesentlichen parallelen ersten Richtungen (Dpa) erstrecken und durch keine weitere erste Erstreckungsrichtung (Dpa) einer ersten parallelen Ausnehmung (7a) voneinander beabstandet sind, kleiner oder gleich 200 mm ist, und/oder
dass der Abstand (d) zwischen zwei ersten parallelen Ausnehmungen (7a), die als "benachbart" bezeichnet werden, d.h. zwei ersten parallelen Ausnehmungen (7a), die sich entlang ihrer größten Abmessung (Lpa) in im Wesentlichen zusammenfallenden ersten Richtungen (Dpa) erstrecken und durch keine weitere erste Ausnehmung (7a) voneinander beabstandet sind, oder zwei ersten parallelen Ausnehmungen (7a), die sich entlang ihrer größten Abmessung (Lpa) in im Wesentlichen parallelen ersten Richtungen (Dpa) erstrecken und durch keine weitere erste Erstreckungsrichtung (Dpa) einer ersten parallelen Ausnehmung (7a) voneinander beabstandet sind, größer oder gleich 40 mm ist, und/oder
dass der Querschnitt (s) des Restmaterials zwischen einer ersten parallelen Ausnehmung (7a) und einer zweiten senkrechten Ausnehmung (7b) größer oder gleich 2 mm² ist.

7. Modul nach einem der vorhergehenden Ansprüche,
**dadurch gekennzeichnet, dass**
- die Ausnehmungen (7) eine Breite (I) größer oder gleich 2 mm haben, und/oder
- die Ausnehmungen (7) eine Breite (I) kleiner oder gleich 3 mm haben, und/oder
- die Ausnehmungen (7) zumindest teilweise nicht durchgehend und teilweise durchgehend sind, und optional
dass die Restdicke (eᵣ) des Materials der zumindest einen aus erster (2) und zweiter (5) Schicht im Bereich der nicht durchgehenden Ausnehmungen (7) kleiner oder gleich 20% der Dicke (e1) des Polymermaterials der zumindest einen aus erster (2) und zweiter (5) Schicht, insbesondere kleiner oder gleich 0,1 mm, ist.

8. Modul nach einem der vorhergehenden Ansprüche,
**dadurch gekennzeichnet, dass** die Ausnehmungen (7) vollständig durchgehend sind.

9. Modul nach Anspruch 7 oder 8,
**dadurch gekennzeichnet, dass** ein Eindringmaterial (8) zumindest teilweise, insbesondere vollständig, die durchgehenden Ausnehmungen (7) und/oder die nicht durchgehenden Ausnehmungen (7) auf der Außenfläche des Fotovoltaikmoduls (1) einnimmt, wobei das Eindringmaterial (8) insbesondere aus dem Material der Einkapselungsanordnung (3) besteht.

10. Modul nach einem der vorhergehenden Ansprüche,
**dadurch gekennzeichnet, dass**:
- die Ausnehmungen (7) in einer Matrixkonfiguration angeordnet sind, d.h. so, dass die Ausnehmungen (7) sich im Wesentlichen in Zeilen und Spalten erstrecken, und/oder
- die Ausnehmungen (7) in einer konzentrischen Konfiguration angeordnet sind, d.h. so, dass zumindest ein Teil der Ausnehmungen (7) im Wesentlichen, allein oder zusammen, Kreisformen oder Kreisbögen definieren.

11. Modul nach einem der vorhergehenden Ansprüche,
**dadurch gekennzeichnet, dass** es ferner eine Gasbarriereschicht (9) enthält, die die zumindest eine aus erster (2) und zweiter (5) Schicht bedeckt und die insbesondere aus einem Schutzfilm (9), Gasbarrierefilm genannt, besteht.

12. Verfahren zur Herstellung eines Fotovoltaikmoduls (1) nach einem der vorhergehenden Ansprüche,
**dadurch gekennzeichnet, dass** es die nachstehenden aufeinanderfolgenden Schritte umfasst:
a) Ausbilden von Ausnehmungen (7) in dem Polymermaterial der zumindest einen aus erster (2) und zweiter (5) Schicht des Fotovoltaikmoduls (1),
b) Laminieren aller Schichten (2, 3, 4, 5), aus denen das Fotovoltaikmodul (1) besteht.

13. Verfahren nach Anspruch 12,
**dadurch gekennzeichnet, dass** Schritt a) der Ausbildung der Ausnehmungen (7) mittels einer Gussform oder einer spanenden Bearbeitung durchgeführt wird.

14. Verfahren nach Anspruch 12 oder 13,
**dadurch gekennzeichnet, dass**
- der Schritt a) der Ausbildung der Ausnehmungen (7) die Ausbildung zumindest einer Vielzahl von durchgehenden Ausnehmungen (7) und/oder gegebenenfalls nicht durchgehenden Ausnehmungen (7) an der Außenfläche des Fotovoltaikmoduls (1) umfasst, und dass
es nach dem Schritt a) der Ausbildung der Ausnehmungen (7) und vor dem Schritt b) der Laminierung den Zwischenschritt a') umfasst, der darin besteht, die zumindest eine aus erster (2) und zweiter Schicht (5), die mit den Ausnehmungen (7) versehen ist, direkt in Kontakt mit der Einkapselungsanordnung (3) anzuordnen, so dass während des Schritts b) der Laminierung das Material der Einkapselungsanordnung (3) schmilzt und zumindest teilweise in die Ausnehmungen (7) eindringt, wobei das Material der Einkapselungsanordnung (3) dann zumindest teilweise das Fugenmaterial bildet, oder
- dass der Schritt a) der Ausbildung der Ausnehmungen (7) die Ausbildung von zumindest einer Vielzahl von durchgehenden Ausnehmungen (7) und gegebenenfalls von nicht durchgehenden Ausnehmungen (7) an der Außenfläche des Fotovoltaikmoduls (1) umfasst, und dass es nach dem Schritt a) der Ausbildung der Ausnehmungen (7) und vor dem Schritt b) der Laminierung den Zwischenschritt a") umfasst, der darin besteht, zumindest ein Eindringmaterial (8) zwischen der Einkapselungsanordnung (3) und der zumindest einen aus erster (2) und zweiter (3) Schicht, die mit den Ausnehmungen (7) versehen sind, anzuordnen, so dass während des Schritts b) der Laminierung das Eindringmaterial (8) schmilzt und zumindest teilweise in die Ausnehmungen (7) eindringt, wobei das Eindringmaterial (8) dann zumindest teilweise das Fugenmaterial bildet, oder
- dass der Schritt a) der Ausbildung der Ausnehmungen (7) die Ausbildung von zumindest einer Vielzahl von durchgehenden Ausnehmungen (7) und gegebenenfalls nicht durchgehenden Ausnehmungen (7) an der Außenfläche des Fotovoltaikmoduls (1) umfasst, und dass es nach dem Schritt a) der Ausbildung der Ausnehmungen (7) und vor dem Schritt b) der Laminierung den Zwischenschritt a'") umfasst, der darin besteht, zumindest ein Eindringmaterial (8) im Inneren der Ausnehmungen (7) anzuordnen und dann die zumindest eine aus erster (2) und zweiter (3) Schicht, die mit den Ausnehmungen (7) versehen ist, die das zumindest eine Eindringmaterial (8) enthalten, direkt mit der Einkapselungsanordnung (3) in Kontakt zu bringen, so dass während des Schritts b) der Laminierung das Eindringmaterial (8), das bereits im Inneren der Ausnehmungen (7) angeordnet ist, dann zumindest teilweise das Fugenmaterial bildet.

15. Verfahren nach einem der Ansprüche 12 bis 14,
**dadurch gekennzeichnet, dass** es nach dem Schritt b) der Laminierung den Schritt c) des Positionierens einer Gasbarriereschicht (9) umfasst, die die zumindest eine aus erster (2) und zweiter (5) Schicht bedeckt und insbesondere aus einem Schutzfilm (9), Gasbarrierefilm genannt, besteht.

## Claims

1. Photovoltaic module (1) comprising at least:
- a first transparent layer (2) forming the front face of the photovoltaic module (1) that will receive a light flux,
- a plurality of photovoltaic cells (4) arranged side by side and electrically connected together,
- an assembly (3) encapsulating the plurality of photovoltaic cells (4),
- a second layer (5) forming the back face of the photovoltaic module (1), the encapsulating assembly (3) and the plurality of photovoltaic cells (4) being located between the first (2) and the second (5) layers,
at least the first (2) or the second (5) layers being composed of at least one polymer material, in which slots (7) are formed making up expansion joints, said at least first (2) or second (5) layer provided with slots (7) being one integral piece,
the slots (7) being at least partially occupied by a "soft" jointing material with a Young's modulus (E) at ambient temperature being less than the Young's modulus at ambient temperature of the polymer material of said at least one of the first (2) and second (5) layer and with a thickness (e2) less than or equal to the thickness (e1) of the polymer material of said at least one of the first (2) or second (5) layers,
**characterised in that** the slots are at least partly open.

2. Module according to claim 1, **characterised in that** the jointing material has a Young's modulus (E) at ambient temperature of 20 times less, or even 100 times or even 500 times or even 1000 times less than the Young's modulus (E) at ambient temperature of the polymer material of said at least one of the first (2) and second (5) layers, and particularly **in that** the jointing material has a Young's modulus (E) at ambient temperature of less than or equal to 50 MPa, or even 30 MPa or even better 10 MPa, whereas the polymer material of said at least one of the first (2) as second (5) layers has a Young's modulus E at ambient temperature equal to between 400 MPa and 10 GPa.

3. Module according to one of the above claims, **characterised in that**:
- the thickness (e1) of the polymer material of said at least one of the first (2) and second (5) layers is between 0.5 and 10 mm, and/or,
- **in that** the coefficient of thermal expansion (CTE) of the polymer material of said at least one of the first (2) and second (5) layers is between 30 and 200 ppm/°C at temperatures close to ambient temperature, and **in that** the coefficient of thermal expansion (CTE) of the jointing material occupying the slots (7) is between 30 and 200 ppm/°C at a temperature close to ambient temperature, and/or
- **in that** said at least one polymer material of said at least one of the first (2) and second (5) layers may be chosen from among poly methyl methacrylate (PMMA), particularly single-phase PMMA or multi-phase (impact) PMMA, particularly nanostructured PMMA, or polycarbonate (PC), and/or
- **in that** the jointing material occupying the slots (7) is chosen from among a polymer material, particularly identical to the polymer material forming the encapsulating assembly (3) or a gas, particularly ambient air.

4. Module according to any one of the above claims, **characterised in that** each of the first (2) and second (5) layers is composed of at least one polymer material, in which slots (7) are formed making up expansion joints, each of the first (2) and second (5) layers provided with slots (7) being one integral piece, and the slots (7) being at least partially occupied by a "soft" jointing material with a Young's modulus (E) at ambient temperature less than the Young's modulus (E) of each of the first (2) and second (5) layers and with a thickness (e2) less than or equal to the thickness (e1) of each of said first (2) and second (5) layers.

5. Module according to any one of the above claims, **characterised in that** the slots (7) are elongated, and in particular are oblong, straight and/or in the form of the arc of a circle.

6. Module according to any one of the above claims, **characterised in that** the slots (7) according to the invention advantageously comprise firstly a set of first slots (7a) said to be "parallel", in other words first slots (7a) for which their largest dimension (Lpa) extends along first directions (Dpa) approximately parallel to each other or coincident with each other, and secondly a set of second "perpendicular" slots 7b, in other words second slots (7b) for which their largest dimension (Lpe) extends along second directions (Dpe) approximately perpendicular to the first directions (Dpa) along which the largest dimension (Lpa) of the first slots (7a) extends, and optionally, **in that** the distance (d) between two so-called "adjacent" first parallel slots (7a), in other words two first parallel slots (7a) for which their largest dimension (Lpa) extends along first directions (Dpa) that are practically coincident with each other and for which there are no other first slots (7a) between them, or two first parallel slots (7a) for which their largest dimension (Lpa) extends along approximately parallel first directions (Dpa) and for which there is no other first direction (Dpa) along which a first parallel slot (7a) extends, is less than or equal to 200 mm, and/or, **in that** the distance (d) between two so-called "adjacent" first parallel slots (7a), in other words two first parallel slots (7a) for which their largest dimension (Lpa) extends along first directions (Dpa) that are practically coincident with each other and for which there are no other first slots (7a) between them, or two first parallel slots (7a) for which their largest dimension (Lpa) extends along approximately parallel first directions (Dpa) and for which there is no other first direction (Dpa) along which a first parallel slot (7a) extends, is greater than or equal to 40 mm, and/or, **in that** the section (s) of material remaining between a first parallel slot (7a) and a second perpendicular slot (7b) is greater than or equal to 2 mm².

7. Module according to any one of the above claims, **characterised in that**:
- the width (I) of the slots (7) is greater than or equal to 2 mm, and/or,
- **in that** the width (I) of the slots (7) is less than or equal to 3 mm, and/or,
- **in that** the slots (7) are partly open, and optionally, **in that** the residual thickness (eᵣ) of material from said at least one of the first (2) and second (5) layers at the blind slots (7) is less than or equal to 20% of the thickness (e1) of the polymer material in said at least one of the first (2) and second (5) layers, particularly less than or equal to 0.1 mm.

8. Module according to any one of the above claims, **characterised in that** the slots (7) are entirely open.

9. Module according to claim 7 or 8, **characterised in that** a penetration material (8) at least partially and particularly entirely occupies through slots (7) and/or blind slots (7) over the external surface of the photovoltaic module (1), the penetration material (8) being composed particularly of the material from which the encapsulating assembly (3) is made.

10. Module according to any one of the above claims, **characterised in that**:
- the slots (7) are set out in a matrix configuration, in other words the slots (76) are approximately in rows and in columns, and/or,
- the slots (7) are set out in a concentric configuration, in other words such that at least part of the slots (7) define shapes of a circle or arcs of circles, either alone or in combination.

11. Module according to any one of the above claims, **characterised in that** it also comprises a gas barrier layer (9) covering said at least one of the first (2) and second (5) layers, particularly composed of a protection film (9), called the gas barrier film.

12. Module according to any one of the above claims, **characterised in that** it comprises the following steps in sequence:
a) make slots (7) in the polymer material of said at least one of the first (2) and second (5) layers of the photovoltaic module (1),
b) lamination of the set of layers (2, 3, 4, 5) forming the photovoltaic module (1).

13. Method according to claim 12, **characterised in that** step a) to make the slots (7) is done using a casting mould or by machining.

14. Method according to claim 12 or 13, **characterised in that**:
- step a) to make the slots (7) includes the formation of a least a plurality of through slots (7), and optionally blind slots (7), on the external surface of the photovoltaic module (1), and **in that** it includes the intermediate step a'), after step a) in which slots (7) are made and before the lamination step b), consisting of placing said at least one of the first (2) and second (5) layers in which slots (7) are formed directly in contact with the encapsulating assembly (3) such that, during the lamination step b), the material of the encapsulating assembly (3) melts and at least partially penetrates into the slots (7), the material of the encapsulating assembly (3) then at least partly forming said jointing material, or,
- **in that** step a) to make the slots (7) includes the formation of a least a plurality of through slots (7), and optionally blind slots (7), on the external surface of the photovoltaic module (1), and **in that** it includes the intermediate step a"), after step a) in which slots (7) are made and before the lamination step b), consisting of placing at least one penetration material (8) between the encapsulating assembly (3) and said at least one of the first (2) and second (3) layers in which slots (7) are formed such that, during the lamination step b), the penetration material (8) melts and at least partially penetrates into the slots (7), the penetration material (8) then at least partly forming said jointing material, or
- **in that** step a) to make the slots (7) includes the formation of a least a plurality of through slots (7), and optionally blind slots (7), on the external surface of the photovoltaic module (1), and that it includes the intermediate step a'"), after step a) in which slots (7) are made and before the lamination step b), consisting of placing at least one penetration material (8) in said slots (7) and then placing said at least one of the first (2) and second (5) layers in which slots (7) are formed comprising said at least one penetration material (8) directly in contact with the encapsulating assembly (3) such that, during the lamination step b), the penetration material (8) already in place inside the slots (7) then at least partly forms said jointing material.

15. Method according to any one of claims 12 to 14, **characterised in that** it also comprises step c) after the lamination step b), in which a gas barrier layer (9) is put into place covering said at least one of the first (2) and second (5) layers, particularly composed of a protection film (9), called the gas barrier film.
